Europäisches Patentamt

European Patent Office

Office européen des brevets

(11) Veröffentlichungsnummer : **0 155 528**
**B1**

(12) EUROPÄISCHE PATENTSCHRIFT

(45) Veröffentlichungstag der Patentschrift :
01.02.89

(51) Int. Cl.⁴ : **G 02 B 6/42,** H 01 L 33/00

(21) Anmeldenummer : 85101906.7

(22) Anmeldetag : 21.02.85

(54) Optoelektronisches Modulgehäuse.

(30) Priorität : 22.02.84 DE 3406424
08.08.84 DE 3429282

(43) Veröffentlichungstag der Anmeldung :
25.09.85 Patentblatt 85/39

(45) Bekanntmachung des Hinweises auf die Patenterteilung : 01.02.89 Patentblatt 89/05

(84) Benannte Vertragsstaaten :
AT CH DE FR GB LI NL SE

(56) Entgegenhaltungen :
EP--A-- 0 031 146
EP--A-- 0 094 274
US--A-- 3 950 075

(73) Patentinhaber : Siemens Aktiengesellschaft Berlin
und München
Wittelsbacherplatz 2
D-8000 München 2 (DE)

(72) Erfinder : Haberland, Detlef, Dr.rer.nat.
Fichtenstrasse 14
D-8031 Steinebach (DE)
Erfinder : Langenwalter, Michael, Dr. phil.
Schulerstrasse 8
D-8035 Stockdorf (DE)
Erfinder : Panzer, Klaus, Dr.-Ing.
Strassberger Strasse 47
D-8000 München 40 (DE)
Erfinder : Rosen, Hans-Georg, Dipl.-Ing.
Weidenstrasse 2
D-8021 Hohenschäftlarn (DE)
Erfinder : Später, Lothar
Am Klingelberg 21
D-6747 Annweiler (DE)
Erfinder : Späth, Werner
Burgstallerstrasse 10
D-8150 Holzkirchen (DE)
Erfinder : Seibert, Bernd
Putzbrunner Strasse 78
D-8012 Ottobrunn (DE)
Erfinder : Haltenorth, Helmut, Dr.
Werner-Friedmann-Bogen 18
D-8000 München 50 (DE)

## Beschreibung

Die Erfindung betrifft eine Weiterentwicklung des im Oberbegriff des Patentanspruchs 1 definierten Modulgehäuses, welches für sich der US-A-3 950 075 entnehmbar ist. Bei der dort beschriebenen Anordnung ist zwar das Bauelement relativ genau, zumindest in zwei Dimensionen radial zur Glasfaser justierbar, bevor eine endgültige Befestigung mittels Schrauben stattfindet. Die Befestigung mittels Schrauben erreicht aber nicht die wünschenswerte Präzision von weit unter 1 μm radial zur Glasfaser. Dermaßen große Unterschiede in der Präzision der Justierung und der endgültigen Befestigung stellen aber einen so großen quantitativen Sprung dar, daß dieser Sprung einem qualitativen Sprung gleichgesetzt werden kann. Die Befestigung mittels Schrauben bewirkt nämlich so starke Verdrückungen in radialer Richtung zur Glasfaser, daß Präzisionen von weit unter 1 μm beim endgültigen Befestigen mittels Schrauben sicher wieder zerstört werden, selbst wenn ursprünglich die Justierung auf weit unter 1 μm genau präzise gewesen wäre.

Bei einem ähnlichen in der europäischen Patentanmeldung E-A2-31 146 angegebenen Modulgehäuse ist die Montage vergleichsweise recht schwierig, besonders weil dort während der Montage zu leicht das empfindliche Glasfaserende beschädigt und/oder verschmutzt wird, z. B. mit Harz, was verstärkt dann gilt, wenn es sich bei dem Glasfaserende um die Taperspitze einer Monomodefaser handelt.

Die Aufgabe der Erfindung besteht darin, ein optoelektronisches Modulgehäuse der eingangs angegebenen Art so zu verbessern, daß eine optimale Justierung des Bauelements und eine endgültige starre Befestigung desselben in dieser optimalen Justierlage mit derselben Präzision möglich ist.

Diese Aufgabe wird durch die im Kennzeichen des Hauptanspruchs angegebenen Merkmale gelöst.

Die Erfindung wurde insbesondere für ein optoelektronisches 200-Megabit/Sekunde-Empfangsmodul und -Sendemodul eines Glasfaser-Fernmeldesystems entwickelt. Sie eignet sich aber darüber hinaus schlechthin für jedes optoelektronische Modulgehäuse, welches über eine Glasfaser Lichtsignale empfängt oder welches über eine Glasfaser Lichtsignale sendet.

Die im Patentanspruch 1 definierte Erfindung gestattet eine Erleichterung der mechanisch-optischen Justierung der Glasfaserachse auf das Bauelement durch die im Patentanspruch 1 angegebenen Maßnahmen auf eine elegante Weise mit sehr hoher Präzision, z. B. auf weit unter 1 μm genau, um die anzustrebende maximale optische Kopplung zwischen der Glasfaser und dem Bauelement zu erreichen. Dabei kann während der Messung und während der Befestigung sowohl der Platte am Justierrahmen als auch des Justierrahmens an der Justierebene auch eine Beschädigung und eine Verschmutzung des Glasfaserendes leicht vermieden werden.

Die Erfindung und deren Weiterbildungen werden durch die in den Figuren gezeigten Schemen von Ausführungsbeispieldetails weiter erläutert, wobei die Figur

1 die Draufsicht auf ein Beispiel der Platte mit Bauelement und Verstärkerelementen,

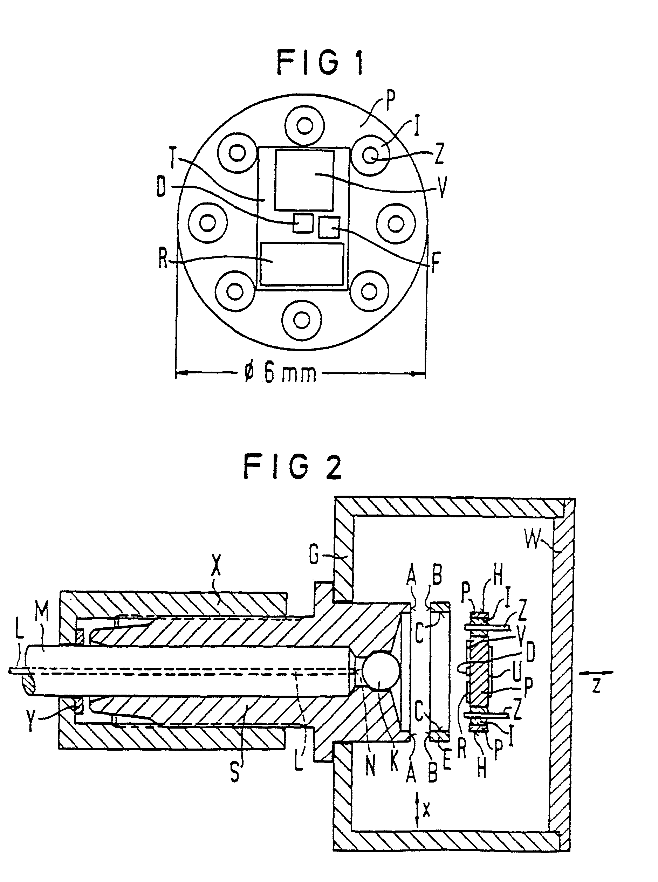

2 eine Anwendung der in Fig. 1 gezeigten Platte in einem aufgeschnitten gezeigten optoelektronischen Modulgehäusebeispiel gemäß der Erfindung,

3 ein anderes Modulgehäusebeispiel gemäß der Erfindung, welches zusätzlich auch über Gehäusezuleitungsstifte auf eine Leiterplatte gesteckt und gelötet werden kann,

4 vergrößerte Ansichten von Schweißstellen, welche zur Befestigung angebracht werden können,

5 ein Beispiel, bei welchem durch vielfaches Punktschweißen eine besonders gut Wärme leitende Befestigung möglich ist,

6 ein Beispiel dafür, wie eine Befestigung durch Laserschweißen, insbesondere Punktschweißen, möglich ist,

7 ein weiteres Modulgehäusebeispiel gemäß der Erfindung, welches neben der Platte noch einen besonderen Gleitkörper aufweist, der für sich an den Justierrahmen geklebt und/oder geschweißt wird,

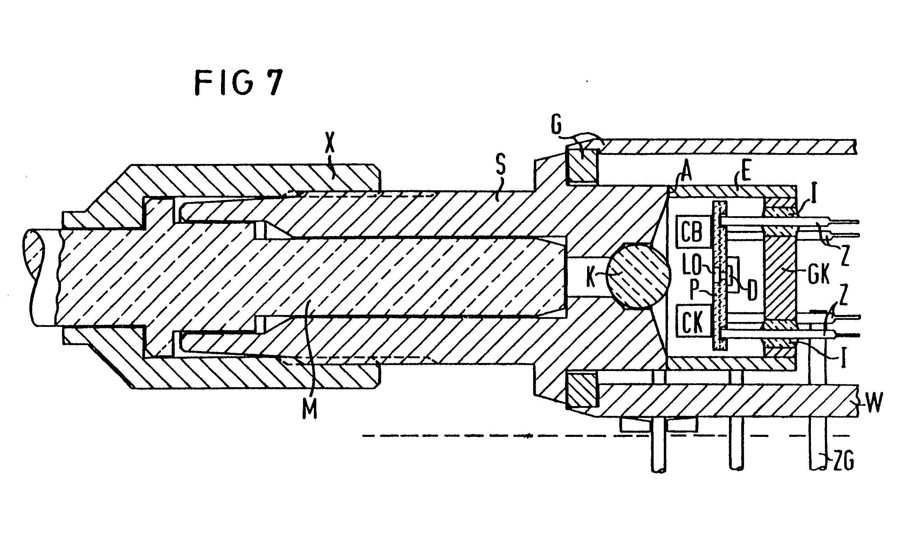

8 ein vergrößertes Detail aus Fig. 7,

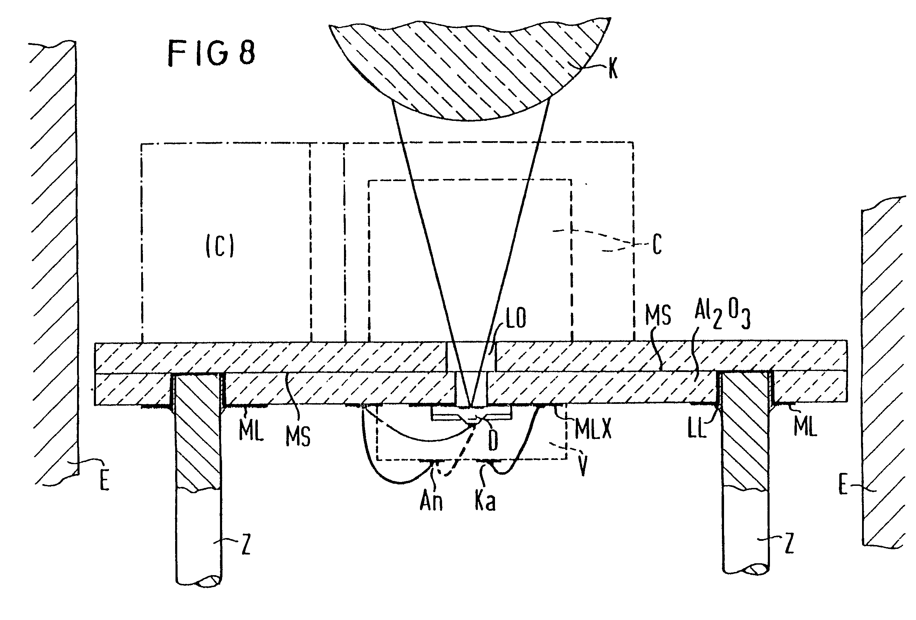

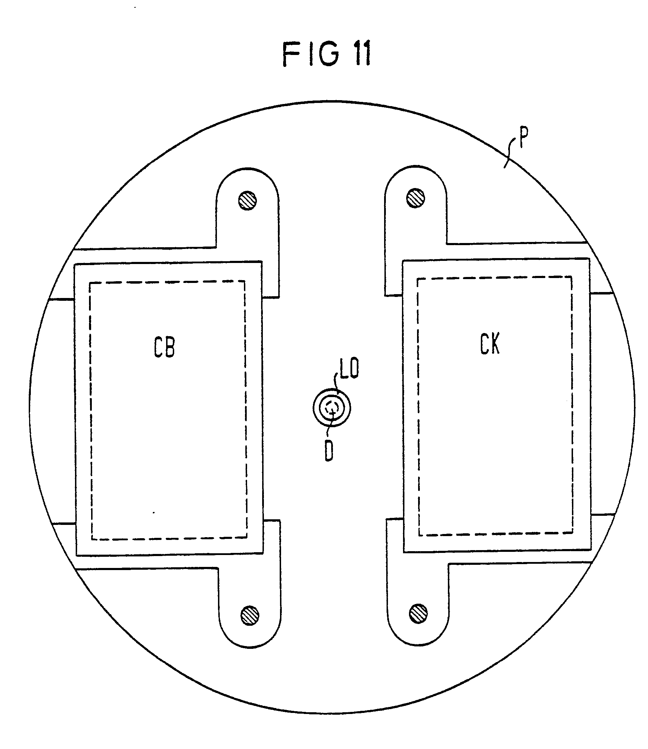

9 ein Schaltungsschema, welches z. B. dem in Fig. 8, 10 und 11 gezeigten besonderen Beispiel einer das Bauelement enthaltenden, dort auf der Platte untergebrachten Schaltungsanordnung zugrundeliegen kann, sowie

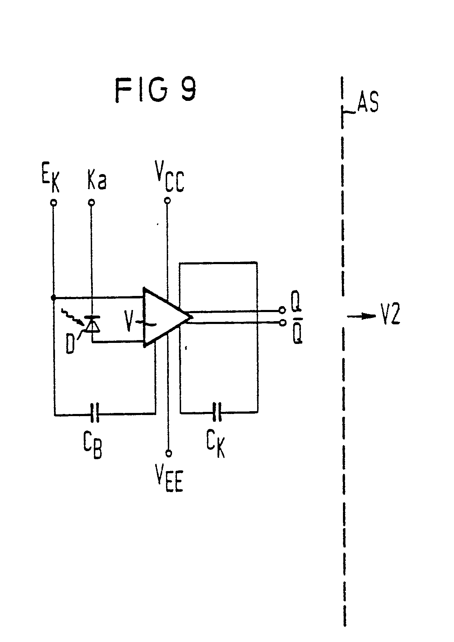

10 und 11 die Ansichten der Vorderseite und der Rückseite eines Beispiels der Platte, auf welcher ein Schaltungsanordnungsbeispiel gemäß Fig. 9 untergebracht ist, zeigen.

Das in Fig. 2 aufgeschnitten gezeigte Schema eines erfindungsgemäß aufgebauten äußeren gasdichten Gehäuses G/W enthält eine Wanne G, sowie einen — bevorzugt licht- und gasdicht — aufsetzbaren und entfernbaren Deckel W, so daß das Innnere dieses Gehäuses G/W für Montagen, Endjustierungen und abschließende Überprüfungen leicht zugänglich ist.

Am Boden der Wanne G ist, wieder bevorzugt licht- und gasdicht, der Glasfaseranschluß S, hier nämlich ein Glasfaserstecker S für einen mittels Schraube X und Anschlag Y festschraubbaren Glasfasersteckstift M, angebracht. Dieser Glasfaseranschluß S dient bei einem Empfangsmodulgehäuse zur Zuführung bzw. bei einem Sendemodulgehäuse zur Wegleitung des mit Informationen modulierten Lichtes durch die Gehäusewand G. In Richtung der Achse des durch die Glasfaser gebildeten Lichtleiters L des Glasfasersteckstiftes M liegt das optoelektronische Bauelement D, welches das Licht empfängt oder sendet, z. B. eine GaAs-PIN-Photodiode D oder eine Laserdiode D.

Im äußeren Gehäuse S/G/W liegt bei diesem Beispiel das eigentliche Modulgehäuse S/E/P mit dem Glasfaseranschluß S, dem Justierrahmen E und der Platte P. Im Prinzip kann das äußere Gehäuse G/W zusätzlich noch andere Elemente, z. B. einen zusätzlichen Vorverstärker oder Nachverstärker enthalten.

Die in Fig. 2 in Seitenansicht aufgeschnitten gezeigte Platte P, welche der in Fig. 1 in Draufsicht gezeigten Platte P entspricht, ist nach dem Justieren in Wahrheit zumindest teilweise in den Justierrahmen E geschoben, so daß sich zumindest Teile der Flächen H und C berühren. Die Fig. 2 stellt also insofern einen Zustand vor dem Justieren dar — oder auch nur eine Explosionsbilddarstellung von dem bereits justierten Justierrahmen E und Platte P. Auch der Justierrahmen E berührt nämlich nach der Justierung zumindest mit einem Teil seiner Fläche B die Justierebene A des Glasfaseranschlusses, der hier im gezeigten Beispiel aus einem Glasfaserstecker S und dessen Steckerstift M mit der Glasfaser L besteht.

Da die Platte P zunächst in Richtung der Glasfaserachse L frei verschiebbar ist und da der Justierrahmen E zunächst auf der Justierebene A in zwei weiteren lateralen Richtungen frei bewegbar ist, ist das auf der Platte P befestigte Bauelement D in allen drei Dimensionen beliebig exakt gegenüber der Lage des Glasfaserendes N justierbar. Nach dieser Justierung ist der Justierrahmen E an der Justierebene A und damit starr endgültig und bleibend am Glasfaserstecker S und damit an der Wanne G befestigbar. Davor oder danach, bevorzugt anschließend, ist auch die Platte P an den Flächen H/C endgültig und bleibend am Justierrahmen E befestigbar. Damit ist das Bauelement D starr in seiner optimalen Justierlage befestigbar, durch Kleben oder Laserpunktschweißen. Diese Justierungen sowie diese endgültigen starren Befestigungen an der Justierebene A, und damit hier im Beispiel an der Wanne G, erfolgen bevorzugt unter ununterbrochener Beobachtung bzw. Messung der optischen Kopplung zwischen dem Glasfaserende N und dem Bauelement D, während einer entsprechenden optoelektronischen Inbetriebnahme des Bauelements D und der Glasfaser L. Damit erreicht man dauerhaft im Modulgehäuse S/E/P, durch — bevorzugt iteratives — Suchen der optischen Justierlage und Befestigen in dieser Justierlage, eine maximale damit optimale optische Kopplung zwischen dem Bauelement D und der Glasfaser L.

Statt des gezeigten Glasfasersteckers S mit Steckerstift M, kann auch ein eine Glasfaser L enthaltender Glasfaseranschluß S starr und unlösbar — statt z. B. mittels der Verschraubung X/Y lösbar — am Modulgehäuse S/E/P und damit an der Justierebene A angebracht sein. Unter Vermeidung der durch eine Lösbarkeit bedingten Toleranzen ist es mit einer starr und unlösbaren Befestitung der Glasfaser nahe ihrem Ende N am Modulgehäuse, bzw. an dem (den) die Justierebene E aufweisenden Körper (n), ·möglich, eine besonders präzise und langzeitstabile Justierung des Glasfaserendes N gegen das Bauelement D zu erreichen.

Der in Fig. 2 gezeigte Justierrahmen E ist zwar ein im wesentlichen kreisrunder Ring, in den die, auch in Fig. 1 gezeigte, runde Platte P geschoben ist. Aber sowohl die Platte P als auch der Justierrahmen E kann auch andere, einander angepaßte Formen aufweisen : Bei quadratischer statt runder Platte P also z. B. eine quadratische Innenöffnung C im Justierrahmen E.

Die Langzeitstabilität der Lage des Glasfaserendes N gegenüber der Justierebene E kann durch eine entsprechend stabile, eine kaum störende Wärmeausdehnung aufweisende Bauweise und Materialwahl für alle Körper, vgl. S, zwischen dem Glasfaserende N und der Justierebene A erreicht bzw. gefördert werden.

Bei dem in Fig. 2 gezeigten Beispiel soll bevorzugterweise jene erste Dimension, in der die Platte P im Justierrahmen E zur Justierung des Bauelementes D bewegt werden kann, mit der Richtung der Achse der Glasfaser L und mit der optisch aktivsten Richtung des Bauelementes D zumindest weitgehend zusammenfallen. Das erleichtert die Optimierung der optischen Kopplung, nämlich die nachträgliche endgültige Justierung der Platte P, besonders wenn der in den zwei anderen Dimensionen verschiebbare Justierrahmen E zumindest angenähert bereits justiert, also in eine optimale Justierlage gebracht ist, z. B. bereits endgültig starr an der Justierebene A im Gehäuse G/W befestigt ist. Diese — jedenfalls weitgehend-endgültige Bewegung und schließliche Befestigung der Platte P im Justierrahmen E kann dann also, wegen des Fluchtens oder weitgehenden Fluchtens der Glasfaserachse L mit dem Bauelement D, relativ spät erfolgen, nämlich auch noch dann, wenn die optische Kopplung zwischen dem auf der Platte P befestigten Bauelement D und der Glasfaser L bereits durch Bewegen und Befestigen des Justierrahmens E an der Justierebene A, also ohne vorheriges endgültiges Befestigen der Platte P, vorläufig optimiert wurde. Eine solche Reihenfolge der schließlichen/endgültigen Befestigung der Teile E/P an der Justierebene A ist besonders dann günstig, wenn — wie häufig besonders bei Monomodeglasfasern L üblich — die schließlich einzuhaltenden Toleranzen für die Lage des Bauelementes D senkrecht zur Richtung der Glasfaserachse z. B. 10-fach enger sind — z. B. ± 0,05 μm betragen — als in Richtung der Glasfaserachse — dort nämlich z. B. ± 0,5 μm.

Die Fig. 2 zeigt ferner ein Linsensystem K zwischen dem Glasfaseranschluß S und dem Bauelement D, welches mindestens eine einzige Linse K, darunter mindestens eine Sammellinse, z. B. eine besonders einfach herstellbare Kugel K, oft auch einen besonders einfach herstellbaren Glaszylinder K, enthalten kann. Die Linsen dienen zur optischen Ankopplung der optisch aktiven Stelle des Bauelementes D an das Glasfaserende N. Sammellinsen in Kugel- oder Kreiszylinderform am Ende einer Glasfaser, zur Bündelung des Lichtes und damit zur Verbesserung optischer Kopplungen bei Glasfaseranschlüssen, sind für sich z. B. durch
- US-PS 3 950 075,
- DE-OS 30-12 118,
- GB-PS 2 002 136,
- DE-OS 28 31 935 und
- DE-OS 27 03 887
vorbekannt.

Es zeigte sich, daß oft bereits eine einzige Linse, also eine Sammellinse, zumindest aber ein mehrlinsiges optisches System zwischen dem Bauelement D und dem Glasfaserende N, auch bei der Erfindung einen besonderen Vorteil ermöglicht : Häufig hat nämlich einerseits die antennenartige Charakteristik der optischen Eigenschaften des Bauelementes D eine relativ breite, gespreizte Keule, also eine breite Lichtabstahlungskeule oder Lichtempfangskeule. Das Glasfaserende N hat andererseits häufig eine antennenartige Charakteristik mit sehr schmaler, scharf gerichteter Keule. Die verschiedenen Keulenformen dieser beiden Teile N/D, ferner auch die verschiedenen absoluten Größen der optisch aktiven Oberflächen dieser beiden Teile N/D lassen sich mit Hilfe solcher — evtl. an ihrer Oberfläche zusätzlich vergüteter — Linsen, aber oft schon ausreichend mit Hilfe einer Kugel K, einander anpassen, wodurch erreichbar ist, daß die Kopplung zwischen dem Bauelement D un dem Glasfaserende N, oft sogar bei besonders großer Toleranz der optimalen Justierlage, verlustarm und auch reflexionsarm wird — wobei also sogar die Toleranz für zulässige Abweichungen der räumlichen Lagen der beiden Teile N/D von der idealsten Justierlage groß wird :

Wenn nämlich das Bauelement D ein Lichtempfangselement D, z. B. eine GaAs-PIN-Diode D ist, dann stört ein unpräzises, von Zeit zu Zeit geändertes Einschieben des Glasfasersteckstiftes M oft nur wenig, weil alles aus dem Glasfaserende N abgestrahlte Licht wegen dessen enger Keule, mittels der entsprechend am Gehäuse befestigten Linse(n) K, stets über die breite Keule der im Lichtbrennpunkt liegenden, optisch aktivsten Stelle der Diode D empfangen werden kann. Der Abstand zwischen dem Glasfaserende N und der/den fest justierten Linse(n) K kann hierbei angenehmerweise oft eine für ein optisches System extrem große Toleranz aufweisen, besonders wenn der Durchmesser des Linsensystems K, insbesondere einer Kugel K als alleinige Linse K, sehr groß gegen den Glasfaserdurchmesser ist. Dies gilt im Prinzip sogar sowohl für Monomodeglasfasern als auch für Multimodeglasfasern.

Wenn hingegen das im Gehäuse justierte Bauelement D Licht aussendet, also z. B. eine breitkeulige Laserdiode D ist, dann kann man die (oder eine der) Linse(n) K — bei geeignet gewähltem Brechungsindex der Linsen K — so dicht neben dem Bauelement D befestigen, daß die gesamte Strahlung des Bauelementes D, trotz ihrer breiten Keule, nur einen kleinen Ausschnitt der benachbarten Linsenoberfläche der (benachbarten) Linse K trifft und als weitgehend parallel gebündelte dünne Strahlung die letzte Linsenoberfläche dieser Linse(n) wieder verläßt. Demnach ist auf diese Weise die breite Keule dieses sendenden Bauelements D, oft ausreichend schon mittels einer Kugel K, an die enge Keule des Glasfaserendes N zur Reduzierung von Reflexionen und Abbildungsungenauigkeiten weitgehend anpaßbar. Die Toleranz für den Abstand zwischen dem Glasfaserende N und der dort benachbarten Linsenoberfläche des Linsensystems K kann angenehmerweise auch hierbei insbesondere durch geeignete Wahl der Linsen fast beliebig groß gemacht werden und auch eine für ein optisches System extrem große Toleranz aufweisen.

In Fig. 1 und 2 ist schematisch angedeutet, daß auf der Platte P noch weitere Elemente angebracht werden können. So kann die Platte P nahe dem Bauelement D mindestens ein Verstärkerelement V, z. B. einen Vorverstärker V, aufweisen, welches hochfrequenzmäßig leitend mit dem Bauelement D verbunden ist — nämlich z. B. mittels möglichst kurzen, kapazitäts- bzw. induktivitätsarmen Bonddrähten, welche in den Figuren der Übersichtlichkeit wegen nicht mehr eingezeichnet sind, auf einem Chip T gemäß der nicht vorveröffentlichten — DE-A-34 09 146. Zusätzlich kann zwischen dem Bauelement D, z. B. einer Licht empfangenden GaAs-PIN-Diode D, und einem Vorverstärker D noch ein weiteres Hochfrequenzelement eingefügt sein, z. B. ein GaAs-FET F zur Anpassung des Spannungspegels der Diode D an den Spannungs- bzw. Strompegel des Verstärkers V; — wieder sind in den Figuren die entsprechenden elektrischen Leitungen wegen der Übersichtlichkeit weggelassen. Außerdem können noch sonstige Elemente dort angebracht sein, z. B. ein Vorwiderstand R des Bauelements D — z. B. auch als gedruckter Dickschichtwiderstand R, besonders falls T eine entsprechende — z. B. keramische — Trägereinheit ist. Hierbei können alle solche Elemente R, F, V, auch zusammen mit dem Bauelement D zunächst auf einer Trägereinheit T (und/oder sofort auf der Platte P) — bevorzugt «Step by Step» — montiert, geprüft, hochfrequenzmäßig verbunden und bei Bedarf justiert worden sein, bevor die Trägereinheit T (bzw. die Platte P) und damit das Bauelement D endgültig auf der Platte P (bzw. im Modulgehäuse S/E/P) befestigt wird, wodurch die Ausschußquote bei der Herstellung des Modulgehäuses entsprechend niedrig gehalten werden kann.

Bevorzugt wird hierbei das Bauelement D in der Mitte der Platte P — dementsprechend oft auch in der Mitte der Trägereinheit T — befestigt, weil dieser — oft weitgehend rotationssymmetrische — Aufbau später die endgültige Justierung des Justierrahmens E auf der Justierebene A, und damit die endgültige Justierung des Bauelementes D gegen das Glasfaserende N erheblich erleichtern kann.

Die Platte P kann an sich auch selbst ein billiges normiertes Teil P sein, vgl. Fig. 1, nämlich z. B. ein etwa 6 mm Durchmesser aufweisender gewöhnlicher Stiftsockel eines TO-Gehäuses mit in Glasisolatoren I eingeschmolzenen Durchführungen E, wobei die elektrischen äußeren Anschlüsse der Elemente D, V, F, R einschließlich der Stromversorgung und Erdung auch über die mitgenormten, in den Isolatoren I eingeschmolzenen Durchführungen Z zur Rückseite der Platte P hindurchgeführt werden können. Damit bleiben diese Anschlüsse der Elemente — auch nach der endgültigen Justierung und starren Befestigung der Platte P an der Justierebene, z. B. nach Abheben des Gehäusedeckels W — für Abschlußprüfungen und für abschließende Verdrahtungen mit äußeren Schaltungsteilen gut zugänglich. Selbst in engsten, kleinsten Modulgehäusen S/E/P sind damit — nach der starren Befestigung an der Justierebene A — selbst viele Elemente, vgl. D, V, F, R, auf engstem Raum, preiswert, gut justiert und geschützt so unterbringbar, daß sie über die Durchführungen Z elektrisch zugänglich bleiben.

Überdies kann nahezu das ganze Modulgehäuse S/E/P, nämlich die Platte P, der Justierrahmen E und der Anschluß S zusammen mit der — evtl. auf einem eigenen, mit dem Glasfaseranschluß S mittelbar oder unmittelbar verbundenen Körper angebrachten — Justierebene A, aus elektrisch leitend miteinander verbundenen, geerdeten Metallmassen gebildet werden. Dadurch wird eine sehr gute Hochfrequenzabschirmung aller in diesem Modulgehäuse S/E/P angebrachten, durch Hochfrequenz und Streukapazitäten leicht störbaren Teile bzw. Elemente D/V/F/R erreichbar. Zum Schutz der Anschlüsse/Durchführungen Z, auch um evtl. noch weitere Elemente außen nahe bei diesen Anschlüssen Z anzubringen, kann um alles herum noch ein äußeres Gehäuse, z. B. mit den Teilen G/W, angebracht werden. Zusätzlich ist dann, wegen der Wärmeleitfähigkeit solcher Metallmassen, die Platte P und damit auch das Bauelement D relativ leicht kühlbar, besonders wenn auch der Glasfaseranschluß S und/oder das Gehäuse G/W, an der Außenoberfläche gut gekühlte Kühlrippen aufweist. Es kann also auch ein hohe Verlustwäremengen abgebendes Bauelement D, insbesondere ein Licht abstrahlendes Bauelement D wie z. B. eine Laserdiode D, von außen gut gekühlt werden. Bei der Erfindung, und auch bei ihren Weiterbildungen sind daher für sich bekannte Kühlmaßnahmen anwendbar, auch die in den nicht vorveröffentlichten Schriften

— DE-OS 34 29 234 = VPA 84 P 1583,
— DE-OS 34 29 281 = VPA 84 P 1584 und
— DE-OS 34 29 269 = VPA 84 P 1585

angegebenen Maßnahmen zur Kühlung von Gehäusen.

Auf der metallischen oder schichtförmig metallisierten, geerdeten Platte P, auf der oft große Platznot herrscht, kann — auch aus Streukapazitätsgründen — auf ihrer rückseitigen Oberfläche, welche abgewandt ist von ihrer das Bauelement D tragenden Oberfläche, demnach auch mindestens noch ein Verstärkerbestandteil U angebracht werden, welcher hochfrequenzmäßig über mindestens eine isolierte Leitung, z. B. über Durchführungen Z der Platte P, elektrisch leitend mit dem Bauelement D oder mit mindestens einem Verstärkerelement V/F verbunden ist. Der Verstärkerbestandteil U kann dann ein Vorverstärker U sein, wenn das Bauelement D Licht, absendet. Der Verstärkerbestandteil U kann ein Nachverstärker U sein, wenn das Bauelement D Licht empfängt. So können also auch störende Hochfrequenzrückkopplungen zwischen diesen Verstärkerbestandteilen U und den Elementen D, V, F, R auf der anderen Plattenseite unterdrückt bzw. gedämpft werden. Wenn das äußere Gehäuse G/W ebenfalls metallisch (oder metallisiert) und geerdet ist, sind diese Verstärkerbestandteile U auch nach außen hin abgeschirmt.

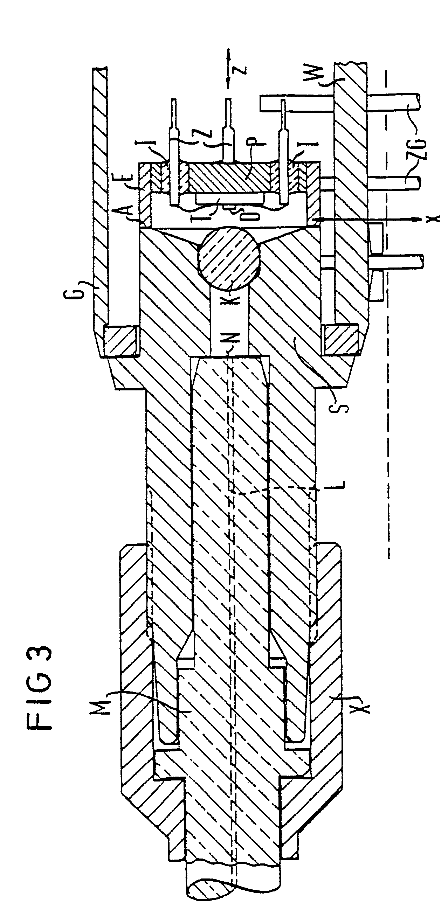

Am äußeren Gehäuse G/W können noch äußere elektrische Anschlüsse angebracht werden. Die Fig. 3 zeigt ein solches Beispiel der Erfindung, bei dem das äußere Gehäuse G/W unten einen Deckel W mit Durchführungsstiften ZG aufweist. Diese Durchführungsstifte ZG dienen einerseits, um über Drähte, die wegen der Übersichtlichkeit in der Fig. 3 nicht gezeigt sind, einzelne Potentiale zu den Durchführungen Z hinzuleiten bzw. von den Durchführungen nach außen hin wegzuleiten. Außerdem kann das Gehäuse G/W dann mittels seiner Durchführungsstifte ZG flach in die Löcher einer Leiterplatte gesteckt und gelötet werden.

Zur endgültigen Befestigung der Platte P am Justierrahmen E und des Justierrahmens E an der Justierebene A eignen sich Kleben oder Laserpunktschweißen. Besonders günstig ist oft das Kleben mit einem aushärtenden Klebemittel. Die Gefahr, daß sich die Justierung nachträglich wegen Nachwirkungen des Klebens wieder verschlechtert, ist im allgemeinen gering, jedenfalls wenn ein Klebemittel verwendet wird, das durch Alterung oder durch die Betriebswärme nicht mehr während der Soll-Lebensdauer zerstört wird.

Zur Befestigung kann man auch — alleine oder zusammen z. B. mit Kleben — Punktschweißen, vor allem Laserpunktschweißen anwenden. Dabei sollte möglichst wenig Verziehen auftreten. Man sollte also nur relativ energiearme Lichtblitze verwenden, und diese möglichst nur, soweit sie zur Befestigung unbedingt nötig sind. Zu viele Aufschmelzungen erhöhen nämlich oft die Gefahr, daß später die Justierung mehr oder weniger wieder zerstört wird. Alleine durch Kleben ist aber manchmal die Abschirmwirkung zu klein, wie schon die Fig. 2 und 3 zeigen.

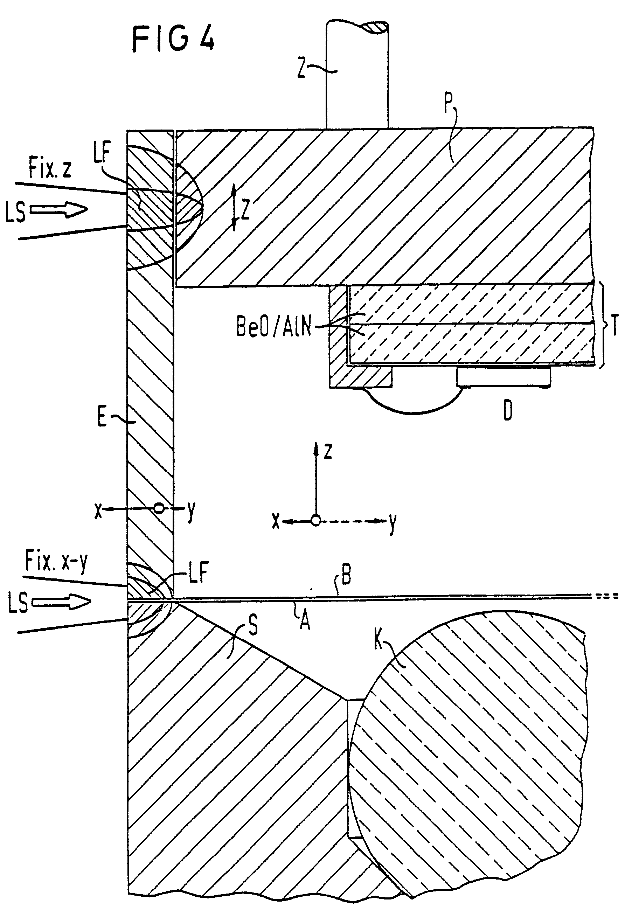

Die Fig. 4, 5 und 6 zeigen beispielhaft, wie mit Punktschweißen, nach dem endgültigen Justieren der Platte P in der z-Dimension und des Justierrahmens E in den x,y-Dimensionen, solche Befestigungen LF mittels Laserlicht LS hergestellt werden können. Die so miteinander verbundenen Teile P/E/S sind, falls diese Teile selbst leitend sind, dann über die Befestigungen LF, also Schweißpunkte LF, auch galvanisch miteinander sicher verbunden, wodurch die Abschirmwirkung gegen Hochfrequenzstörungen verbessert bzw. sichergestellt ist, vergl. auch Fig. 2 und 3. Die gute Abschirmwirkung ist häufig erforderlich auch gegen die Umgebung außerhalb des inneren Modulgehäuses S/E/P; — der Eingang des Verstärkersbestandteils U und/oder des Verstärkerelementes V, vgl. Fig. 2, würde eine gute Empfangsantenne und/oder Sendeantenne für Störimpulse aus der Umwelt und/oder in die Umwelt darstellen, wobei solche Verstärker U,V im allgemeinen überdies rein digital mit extrem steilen Stromimpulsflanken z. B. bei mehreren Hundert Megabit/Sekunde Impulsfolgefrequenz arbeiten. Das Punktschweißen bzw. Laserschweißen kann daher einen zusätzlichen Aufwand von Schirmblechen zwischen den einzelnen Verstärkerstufen U,V innerhalb desselben Modulgehäuses ersparen. Speziell dann, wenn das Bauelement D keine Empfangs-Fotodiode D sondern eine Lichtsendediode D, z. B. eine IRED-Diode ist, können über solche geschweißte Befestigungen LF die dann oft besonders hohen Verlustwärmemengen ausreichend nach außen an äußere Kühlmedien abgeführt werden, z. B. 200 mW Verlustwärme mittels ausreichend geringer Wärmewiderstände zwischen dem Bauelement D und der Oberfläche des Modulgehäuses S/E/P bzw. des Gehäuses S/G/W. Die Lebensdauer insbesondere von IRED-Lichtsendedioden D ist um so kürzer, je höher ihre Sperrschichttemperatur im Betrieb ist, so daß die durch Punktschweißen erreichbare gute Kühlung überdies die Lebensdauer dieser Diode D verlängert.

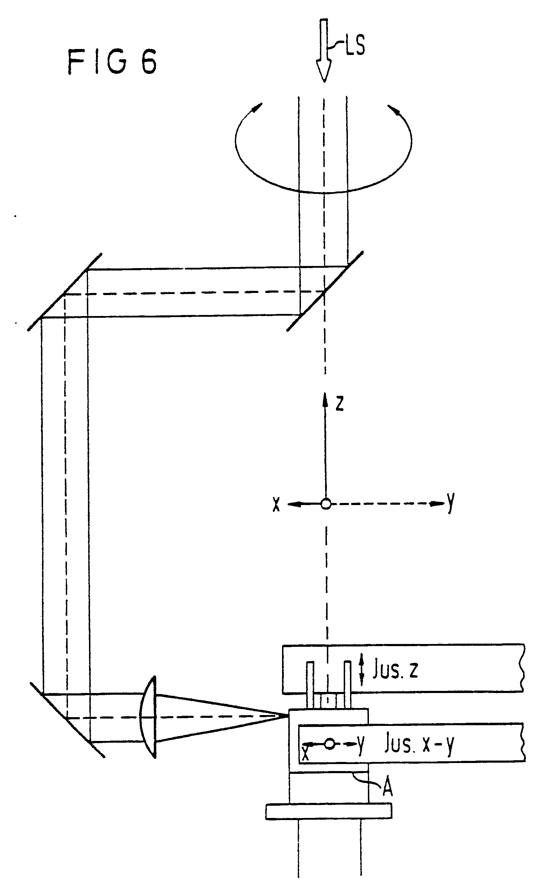

Das Schweißen, insbesondere Punktschweißen, mittels Laser kann berührungslos — z. B. mittels einer rotierfähigen Laserlichtumlenkung und mittels eines z. B. auf 0,05 μm genau justierenden, piezoelektrisch betriebenen Mikromanipulators mit dem die Platte P justierenden Greifarm Jus.z und dem den Justierrahmen E justierenden Greifarm Jus.x-y gemäß Fig. 6 durchgeführt werden. Dabei kann das gegenseitige Justieren der z. B. mit zuerst noch flüssigem Klebemittel benetzten, zu verschweißenden Teile P/E/S/ zuerst durchgeführt werden — die anschließende genügend vorsichtige berührungslose Verschweißung mit Laser LS beeinflußt die Justierung meistens ausreichend gering, vor allem wenn man für eine ausreichende Kühlung während des Schweißens sorgt.

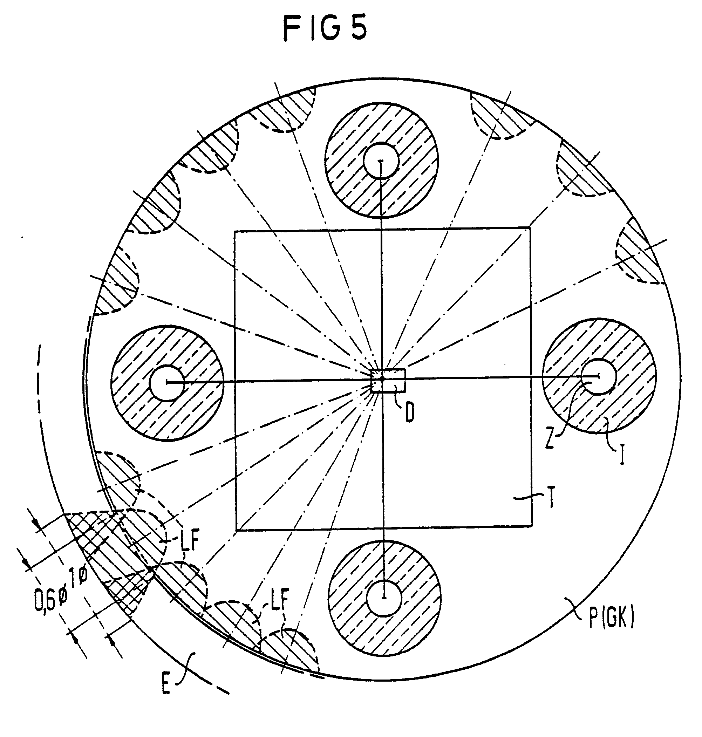

Die Anzahl der auf dem Umfang verteilten Schweißpunkte LF kann an sich beliebig gewählt werden. Aus Fig. 5 ist erkennbar, daß auch 12, 16 oder 20 Schweißpunkte LF à 0,6 mm Durchmesser zwischen der Platte P und dem Justierrahmen E gewählt werden können, wobei ein gewisses Optimum der Wärmeableitung spätestens dann erreicht ist, wenn sich die Schweißpunkte LF gegenseitig überlappen, z. B. 20 Schweißpunkte LF. Oft genügen aber bereits viel weniger Schweißpunkte LF. Je höher die Anzahl der Schweißpunkte LF ist, um so geringer ist der Wärmewiderstand am verschweißten Spalt/Übergang P/E. Die Schweißnaht, insbesondere Punktschweiß-Punkte LF, werden dabei bevorzugt zwischen den Glasisolierungen I der Pins/Durchführungen Z angebracht, vgl. Fig. 5, d. h. zur Schonung der Glasisolierungen I werden also in der Nähe der Glasisolierungen I keine Verschweißungen LF mehr durchgeführt. Im übrigen sind diese Glasisolierungen I für sich stark wärmeisolierend, nicht nur galvanisch isolierend, wodurch der Wärmefluß ohnehin nicht über diese Glasperlen I fließt, sondern über die Plattenabschnitte zwischen den Glasperlen I hindurch und dann weiter über die Verschweißungen LF zum Justierrahmen E hin. Dieser Wärmefluß ist auch beeinflußbar durch die Wahl des Werkstoffes und der Dicke der Platte P und des Justierrahmens E.

Bei dem in Fig. 6 gezeigten Beispiel ist vor allem der Greifarm Jus.z für die z-Dimension gleichzeitig zur Zuführung von Potentialen zum Bauelement D ausnutzbar, so daß während der Justierung, auch während der Schweißung, dem Bauelement D, auch Elementen wie U/V, Betriebsspannungen zugeführt werden können, wodurch die Justierung und Verschweißung unter Kontrolle der optimalen optischen Kopplung zwischen dem Bauelement D und dem Glasfaserende N sogar unter Betriebsbedingungen durchgeführt werden kann. Der Greifarm Jus.z für die z-Dimension sowie der Greifarm Jus.x-y für die x,y-Dimensionen können also sogar zu einem automatisch gesteuertem Mikromanipulator gehören, der automatisch zunächst, z. B. iterativ, die optimale Justierlage sucht und schließlich die Befestigung überwacht, — selbst wenn statt Laserschweißen ein anderes Befestigungsverfahren, z. B. nur Kleben, gewählt wird.

Bei der Erfindung ist aber nicht nötig, die in der ersten Dimension z im Justierrahmen E zunächst frei bewegliche Platte P schließlich selbst unmittelbar am Justierrahmen E zu befestigen. Die zunächst frei bewegliche Platte P kann auch unmittelbar, oder nur mittelbar, starr an einem Gleitkörper befestigt sein, der seinerseits selber zunächst im Justierrahmen E mehr oder weniger gleitet und dort in der z-Dimension frei beweglich ist, auch frei über die optimale Justierlage hinaus. Wenn, nach dem Justieren des Gleitkörpers GK und damit des Bauelementes D in dessen optimaler Justierlage durch z. B. iteratives Bewegen des Gleitkörpers, dieser Gleitkörper seinerseits am Justierrahmen E endgültig befestigt wird, z. B. ähnlich wie in Fig. 6 durch Laserschweißen, ist damit auch die Platte P mit ihrem Bauelement D in ihrer optimalen Justierlage befestigt.

Ein Beispiel für ein erfindungsgemäß aufgebautes Modulgehäuse mit einem solchen Gleitkörper GK wird anhand der Fig. 7 bis 11 erläutert. Das Bauelement D und die Platte P sind bei dem gezeigten Beispiel nicht unmittelbar auf dem hier metallischem Gleitkörper GK befestigt, sondern mit Abstand zum Gleitkörper GK ; — hier mittelbar über die Durchführungen Z. Dadurch ist eine elektrische Trennung des Potentials des Gleitkörpers GK vom Potential des Bauelements D — und bei Bedarf auch der Platte — möglich.

Das Bauelement D ist hier z. B. eine PIN-Fotodiode D mit ihren Anschlüssen An/Ka. Sie ist in diesem Beispiel rückseitenbeleuchtet, vgl. Fig. 7 und 8, z. B. damit die Eingangskapazität des benachbarten Verstärkerelementes V/Verstärkers V, vgl. Fig. 8 und 10, minimal bleibt.

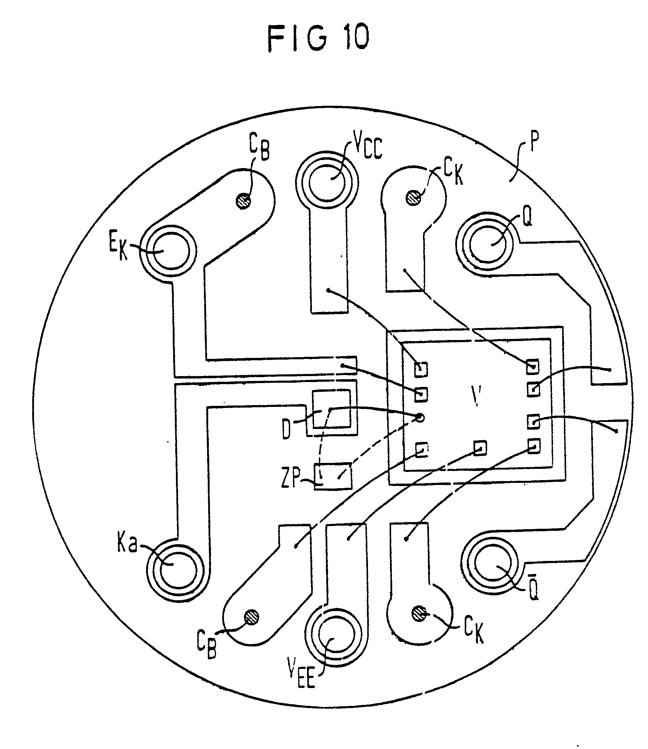

Bei dem in Fig. 10 gezeigten Beispiel ist dieser Verstärker zwar neben dem Bauelement D, hier der Diode D, angebracht, der Verstärker zusammen mit der Diode D kann hierbei jedoch auch, z. B. wie in der — DE-A-34 09 146, eine einzige Baueinheit bilden. Durch die Verringerung der Eingangskapazität des Verstärkers V und durch die Kürze der bei dieser Variante besonders kurz machbaren Hochfrequenzleitungen zum Bauelement D, kann die Bitrate, meßbar in MBit/sec, besonders hoch gemacht werden. Günstig ist, das Bauelement D, hier also z. B. die Fotodiode D, so anzubringen und so aufzubauen, daß die Eingangskapazität, welche am Verstärker V wirkt, z. B. möglichst kleiner als ca. 0,5 pF ist. Eine PIN-Fotodiode D hat selbst eine Kapazität zwischen ihrem p-n-Übergang und Kontakt-Pad von z. B. 0,3 pF, wenn keine weiteren potentialbehafteten Flächen auf der Anodenseite sind. Durch solche Dimensionierungen lassen sich Bitraten von deutlich über 50 MBit/sec für den Betrieb des Bauelementes D erreichen.

Das Bauelement D sitzt hier geschützt auf der «Rückseite» einer gestuften Bohrung LO in der Platte P, vgl. die Bohrung LO in den Figuren 7, 8 und 11, besonders auch um Abschattungseffekte zu vermeiden; — statt der dort gezeigten gestuften Bohrung LO kann dazu dort auch z. B. eine konische Bohrung angebracht sein, vgl. Fig. 8. Die Platte P mit dem Loch für den Strahlungskegel kann z. B. im Durchlaufverfahren gesintert sein und der Konus einen Winkel von 30 Grad bei einer Kugel K als Linse mit einer Brechzahl von z. B. 1,5 aufweisen. Zur Erzeugung derartiger Bohrungen LO kann man auch noch andere Verfahren verwenden, z. B. Bohren mit Laserstrahlen, Ultraschall oder Diamantbohrer, wobei insbesondere auf möglichst gut definierte Konuswinkel bei Wahl einer konischen Bohrung geachtet werden sollte und wobei schiefe Bohrungsachsen sowie scharfe Kanten am Übergang zur Plattenoberfläche möglichst vermieden werden sollten. Die Bohrung sollte in jedem Falle möglichst so gestaltet sein, daß sie gestattet, die optische Kopplung zwischen dem Glasfaserende N und der optisch aktiven Stelle des Bauelementes D in jeder Hinsicht zu optimieren, insbesondere die optimale Justierlage ohne Abschattung einzustellen.

Die Platte P kann auch aus ungebrannter, also «grüner» Keramik, aus $Al_2O_3$ oder auch aus BeO gefertigt, z. B. gesintert oder gestanzt sein, z. B. in einem Durchlaufverfahren gesintert sein, ferner bedruckt mit Dickschichtpasten sein, auch zusammengesetzt aus zwei Schichten à z. B. 200 µm Dicke sein, vgl. Fig. 8. Eine Sinterung im Durchlaufverfahren gestattet, ebenso wie bei Anwendung einer Preßtechnik, jeweils definierte konische oder abgestufte Bohrungen LO zu erzielen. Zur Herstellung von solchen Bohrungen sind auch mehrere Verfahren wie Pressen, Laserstrahlbohren, Ultraschallbohren oder Diamantbohren kombinierbar, was hinsichtlich Preis oft günstig ist. Die Platte P kann aber auch alleine durch Preßtechniken geformt werden, was besonders bei sehr hohen Stückzahlen wirtschaftlich, also günstig ist.

Macht man die Platte P, welche z. B. eine Schaltung mit einem Vorverstärker V mit Ausgängen Q/Q̄ zu einem Nachverstärker V2 außerhalb einer Abschirmung AS gemäß Fig. 9 trägt, aus zwei isolierenden Schichten, vergl. Fig. 7 und 8, — auch bei den in den Fig. 2 und 3 gezeigten Beispielen ist dies alles im Prinzip möglich-, dann kann eine solche Platte P auch zusätzlich innen eine elektrische Abschirmung/Metallebene MS enthalten, welche bei Bedarf auch zur Potentialweiterleitung, also z. B. als Elektrode eines Kondensators ausgebildet sein kann. Diese Metallebene MS und eine oberflächlich angebrachte Metallisierung MLX kann vorteilhafterweise auch genutzt werden, um sogar noch weitere Elemente, z. B. noch weitere Kondensatoren anbringen zu können, z. B. zusätzlich zu den in den Fig. 7, 8 und 9 und 11 gezeigten beiden Kondensatoren CK, CB — vgl. auch deren Anschlüsse CB, CK in den Fig. 9, 10 und 11. Auf der Vorderseite und auf der Rückseite der Platte P ist nämlich oft kaum noch Platz für weitere Elemente wie Kondensatoren. Bei Anbringung von z. B. einigen mm² großen metallisierten Flächen, vgl. MS/MLX, im Abstand von z. B. 0,2 mm sind nämlich Kapazitäten von z. B. 3 pF herstellbar, welche hochfrequenztechnisch oft nützlich sind.

Sowohl die Vorderseite als auch die Rückseite der Platte P können also neben dem Bauelement D zusätzliche elektronische Elemente und Leiterstrukturen tragen, vergl. die genannten Kondensatoren, was insbesondere bei der Verwendung der «grünen» Keramik leicht möglich ist.

Auf der Rückseite der Platte P sind außerdem die Befestigungspunkte der in dem Gleitkörper GK eingeglasten Pins/Durchführungen Z als Sacklöcher ausgebildet, vgl. Fig. 7, 8 und 10, um gute Kontaktierungen ML, z. B. mit Lot oder Silberleitkleber LL, sowie eine ausreichende mechanische Festigkeit sicherzustellen. Ein sacklochloses Aufsetzen der Platte P auf die Stirnflächen der Pins Z ergibt zwar oft bereits ausreichend sichere Kontakte, aber oft zu geringe mechanische Festigkeiten, welche nicht mehr einen Test mit Schwingungsprüfungen oder mechanischen Schockprüfungen bis z. B. 1000 g aushalten würden. Durch die Anwendung von Sacklöchern wird auch die senkrecht zur Pinachse orientierte Stirnfläche/Oberseite der Pins Z zur Montage mit ausreichend enger Toleranz ausnutzbar, wobei sowohl an der Stirnfläche als auch an der Mantelfläche der Pins Z elektrisch kontaktiert werden kann.

Das Bauelement D, z. B. die PIN-Fotodiode D, ist — nach erfolgter Montage der Platte P auf die Pins Z und auf den Gleitkörper GK — mechanisch kaum mehr zugänglich und damit mechanisch gut geschützt, wenn man von der Bohrung LO absieht. Das Bauelement D, also z. B. die PIN-Fotodiode D, ist jedoch elektrisch z. B. zu Prüfzwecken oder für Schadensanalysen über Pins Z zugänglich, vgl. auch Fig. 9. Dies ist oft wichtig z. B. für «burn-in» der Diode D, für Halterungsprüfungen und für Qualifikationsfeststellungen, wobei die Prüfungen bei Bedarf im Prinzip auch unabhängig von der Funktion des Verstärkers V durchführbar ist.

## Patentansprüche

1. Optoelektronisches Modulgehäuse (S/E/P in Figur 2 und 3, S/E/G, in Figur 7), insbesondere gasdichtes (S/G/W in Figur 2, 3 und 7) Lichtempfangsmodulgehäuse mit

— einem Glasfaseranschluß (S), z. B. Glasfaserstecker (S), zur Zuführung bzw. Wegleitung von mit Informationen moduliertem Licht, wobei dieser Glasfaseranschluß (S) eine senkrecht zur optischen Glasfaserachse (L) orientierte Justierebene (A) in einem bereits endgültig definierten Abstand vom Glasfaserende (N) enthält,

— einem Justierrahmen (E), welcher auf der Justierebene (A) befestigbar ist, und

— einem optoelektronischen Bauelement (D) im Inneren des Justierrahmes (E),

dadurch gekennzeichnet, daß zur Justierung in den drei Koordinaten

— das Bauelement (D) auf einer Platte (P) angebracht ist, welche während einer Messung der optischen Kopplung zwischen dem Bauelement (D) und dem Glasfaserende (N) im Innern (C) des Justierrahmens (E) in einer ersten Dimension (z) axial zur Glasfaser über die optimale Justierlage hinaus beweglich und in der optimalen Justierlage im Justierrahmen (E) durch Kleben oder Laserpunktschweißen befestigt ist, sowie

— der Justierrahmen (E) mit der Platte (P) während der Messung der optischen Kopplung in den zwei weiteren Dimensionen (x, y) radial zur Glasfaser frei über die optimale Justierlage hinaus auf der Justierebene (A) beweglich und in der optimalen Justierlage an der Justierebene durch Kleben oder Laserpunktschweißen befestigt ist.

2. Modulgehäuse nach Patentanspruch 1, dadurch gekennzeichnet, daß

— der Abstand des Glasfaserendes (N) zur Justierebene (A) im wesentlichen durch eine Kaum störende Wärmeausdehnung aufweisende Bauweise und Materialwahl für alle Körper (S) zwischen Glasfaserende (N) und der Justierebene (A) festgelegt ist.

3. Modulgehäuse nach Patentanspruch 1 oder 2, dadurch gekennzeichnet, daß

— die erste Dimension (z) zumindest weitgehend mit der Richtung der Glasfaserachse (L) und mit der optisch aktivsten Richtung des Bauelements (D) zusammenfällt.

4. Modulgehäuse nach einem der vorhergehenden Patentansprüche, dadurch gekennzeichnet, daß

— das Bauelement (D) auf der dem Glasfaserende (N) abgewandten Seite der Platte (P), hinter einem Loch (LO) der Platte (P), befestigt ist (Fig. 7, 8, 10, 11).

5. Modulgehäuse nach einem der vorhergehenden Patentansprüche, dadurch gekennzeichnet, daß

— die Platte (P) mittelbar (Z) oder unmittelbar an einem Gleitkörper (GK) starr befestigt ist, und

— unmittelbar nur der in der ersten Dimension (z) in dem Justierrahmen (E) bewegliche Gleitkörper (GK) schließlich im Justierrahmen (E) befestigt wird (Fig. 7, 8).

6. Modulgehäuse nach einem der vorhergehenden Patentansprüche, dadurch gekennzeichnet, daß

— zwischen dem Glasfaserende (N) und der optimalen Justierlage des Bauelementes (D) mindestens eine Linse (K), darunter mindestens eine Sammellinse insbesondere Kugel (K), angebracht ist.

7. Modulgehäuse nach einem der vorhergehenden Patentansprüche, dadurch gekennzeichnet, daß

— auf der Oberfläche der Platte (P), welche das Bauelement (D) trägt, nahe dem Bauelement (D) mindestens ein Verstärkerelement (V), welches hochfrequenzmäßig mit dem Bauelement (D) verbunden ist, angebracht ist.

8. Modulgehäuse nach einem der vorhergehenden Patentansprüche, dadurch gekennzeichnet, daß

— die eine geerdete metallische Fläche enthaltende oder bildende Platte (P) auf einer ihrer Oberflächen, welche abgewandt ist von ihrer das Bauelement (D) tragenden Oberfläche, mindestens ein Verstärkerbestandteil (U) trägt, welches hochfrequenzmäßig über mindestens eine isolierte Leitung (Z), z. B. über Durchführungen (Z) der Platte (P), mit dem Bauelement (D) mittelbar oder unmittelbar verbunden ist.

## Claims

1. Optoelectronic module housing (S/E/P in Figures 2 and 3, S/E/G in Figure 7), especially gastight (S/G/W in Figures 2, 3 and 7) optical receiver module housing having

— a glass fibre terminal (S), e. g. glass fibre connector (S), for supplying or transporting light modulated by formation, this glass fibre terminal (S) containing an adjusting plane (A), which is oriented perpendicular to the optical glass fibre axis (L) at an already definitively determined distance from the glass fibre end (N),

— an adjusting frame (E), which can be fixed against the adjusting plane (A), and

— an optoelectronic component (D) in the interior of the adjusting frame (E),

characterized in that for making adjustments in the three coordinates

— the component (D) is mounted on a plate (P), which, during a measurement of the optical coupling between the component (D) and the glass fibre end (N), can be moved beyond the optimal adjusting position in the interior (C) of adjusting frame (E) in a first dimension (z) axial to the glass fibre, and, in the optimal adjusting position, is fixed by bonding or laser-beam spot welding in the adjusting frame (E), and

— during the measurement of the optical coupling the adjusting frame (E) with the plate (P) can be moved freely beyond the optimal adjusting position on the adjusting plane (A) in the two further dimensions (x, y) radial to the glass fibre,

and, in the optimal adjusting position, is fixed by bonding or laser-beam spot welding to the adjusting plane.

2. Module housing according to Patent Claim 1, characterized in that
— the distance from the glass fibre end (N) to the adjusting plane (A) is essentially determined by a design having a thermal expansion with practically no disturbing effect, and by choice of material for all bodies (S) between glass fibre end (N) and the adjusting plane (A).

3. Module housing according to Patent Claim 1 or 2, characterised in that
— the first dimension (z)coincides at least largely with the direction of the glass fibre axis (L) and with the optically most active direction of the component (D).

4. Module housing according to one of the preceding patent claims,
characterized in that
— the component (D) is fixed behind a hole (LO) of the plate (P) on the side of the plate (P) facing away from the glass fibre end (N) (Figures 7, 8, 10, 11).

5. Module housing according to one of the preceding patent claims,
characterized in that
— the plate (P) is rigidly fixed indirectly (Z) or directly to a sliding body (GK) and
— finally only the sliding body (GK) which can be moved in the first dimension (z) in the adjusting frame (E) is directly fixed in the adjusting frame (E) (Figures 7, 8).

6. Module housing according to one of the preceding patent claims,
characterized in that
— at least one lens (K), including at least one collector lens, especially sphere (K), is mounted between the glass fibre end (N) and the optimal adjusting position of the component (D).

7. Module housing according to one of the preceding patent claims,
characterized in that
— at least one amplifier element (V), which is connected at a high frequency to the component (D), is mounted near the component (D) on the surface of the plate (P), which carries the component (D).

8. Module housing according to one of the preceding patent claims,
characterized in that
— on one of its surfaces facing away from its surface carrying the component (D), the plate (P) containing or forming an earthed metallic area carries at least one amplifier component (U), which is connected at a high frequency indirectly or directly to the component (D) via at least one insulated line (Z), e. g. via feed-throughs (Z) of the plate (P).

**Revendications**

1. Boîtier de module optoélectronique (S/E/P sur les figures 2 et 3, S/E/G sur la figure 7),
notamment boîtier de module de réception de la lumière, étanche au gaz (S/G/W sur les figures 2,3 et 7), comportant
— un raccord (S) pour une fibre de verre, notamment un connecteur (S) pour une fibre de verre, servant à amener et retransmettre une lumière modulée par des informations, ce raccord (S) pour les fibres de verre contenant un plan d'ajustement (A) orienté perpendiculairement à l'axe optique (L) de la fibre de verre et situé à une distance, déjà définie de façon définitive, de l'extrémité (N) de la fibre de verre,
— un cadre d'ajustement (E), qui peut être fixé sur le plan d'ajustement (A), et
— un composant optoélectronique (D) situé à l'intérieur du cadre d'ajustement (E),
caractérisé par le fait que pour réaliser l'ajustement suivant les trois coordonnées
— le composant (D) est disposé sur une plaque (P) qui, pendant une mesure du couplage optique entre le composant (D) et l'extrémité (N) de la fibre de verre, dans l'espace intérieur (C) du cadre d'ajustement (N) dans une première dimension (z), axialement par rapport à la fibre de verre, au-delà de la position optimale d'ajustement et est fixé par collage ou par soudage par points au laser dans la position optimale d'ajustement dans le cadre d'ajustement (N), et
— pendant la mesure du couplage optique, le cadre d'ajustement (E) est déplaçable librement, avec la plaque (B), dans les deux autres dimensions (x, y) radialement par rapport à la fibre de verre au-delà de la position optimale d'ajustement en direction du plan d'ajustement (A) et est fixé dans la position optimale d'ajustement sur le plan d'ajustement par collage ou par soudage par points au laser.

2. Boîtier pour module suivant la revendication 1, caractérisé par le fait que la distance entre l'extrémité (N) de la fibre de verre et le plan d'ajustement (A) est déterminée essentiellement à partir d'une construction et d'un choix des matériaux, qui fournissent une dilatation thermique très peu gênante, pour tous les corps (S) situés entre l'extrémité (N) de la fibre de verre et le plan d'ajustement (A).

3. Boîtier pour module suivant la revendication 1 ou 2, caractérisé par le fait que la première direction (Z) coïncide au moins dans une large mesure avec la direction de l'axe (N) de la fibre de verre et avec la direction, active du point de vue optique, du composant (D).

4. Boîtier pour module suivant l'une des revendications précédentes, caractérisé par le fait que le composant (D) est fixé sur la face de la plaque (P), tournée à l'opposé de l'extrémité (N) de la fibre de verre, en arrière d'un trou (LO) de la plaque (B) (figures 7, 8, 10, 11).

5. Boîtier pour module selon l'une des revendications précédentes, caractérisé par le fait que
— la plaque (P) est fixée de façon rigide indirectement (Z) ou directement sur un corps coulissant (GK), et
— seul le corps coulissant (GK) mobile dans la première dimension (z) dans le cadre d'ajustement (D) est finalement fixé directement dans le cadre d'ajustement (E) (figures 7, 8).

6. Boîtier pour module suivant l'une des revendications précédentes, caractérisé par le fait qu'entre l'extrémité (N) de la fibre de verre et la position optimale d'ajustement du composant (D) se trouve disposée au moins une lentille (K), à savoir au moins une lentille convergente, notamment une sphère (K).

7. Boîtier pour module suivant l'une des revendications précédentes, caractérisé par le fait que sur la surface de la plaque (P) portant le composant (D) se trouve disposé, à côté de ce dernier, au moins un élément amplificateur (V) qui est relié au composant (D) d'une manière convenant pour la transmission des hautes fréquences.

8. Boîtier pour module suivant l'une des revendications précédentes, caractérisé par le fait que la plaque (P) contenant ou formant une surface métallique raccordée à la terre porte, sur l'une de ses surfaces qui est tournée à l'opposé de sa surface portant le composant (D), au moins un composant amplificateur (U), qui est relié directement ou indirectement au composant (D) d'une manière permettant de transmettre les hautes fréquences, par l'intermédiaire d'au moins un conducteur isolé (Z), par exemple au moyen de traversées (Z) ménagées dans la plaque (P).

# FIG 1

# FIG 2

1

FIG 3

EP 0 155 528 B1

# FIG 4

Z

P

Fix. z

LF

LS

Z

BeO/AlN

T

E

D

z

x — y

x ----- y

Fix. x-y

LF

B

LS

A

S

K

# FIG 5

FIG 6

LS

z

x ——○—— y

Jus. z

x ——○—— y    Jus. x-y

A

# FIG 7

EP 0 155 528 B1

# FIG 8

EP 0 155 528 B1

# FIG 9

# FIG 10

# FIG 11